(19)

Europäisches
Patentamt
European
Patent Office
Office européen
des brevets

(11)  **EP 4 167 148 A1**

(12)  **EUROPEAN PATENT APPLICATION**

(43) Date of publication:
**19.04.2023  Bulletin 2023/16**

(21) Application number: **21306426.4**

(22) Date of filing: **12.10.2021**

(51) International Patent Classification (IPC):
**G06N 10/20** (2022.01)       **G06N 10/40** (2022.01)

(52) Cooperative Patent Classification (CPC):
**G06N 10/20; G06N 10/40**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Centre national de la recherche scientifique**
**75016 Paris (FR)**

• **Université Côte d'Azur**
**06100 Nice (FR)**

(72) Inventor: **KAISER, Robin**
**06330 Roquefort-les-Pins (FR)**

(74) Representative: **Osha Liang**
**2, rue de la Paix**
**75002 Paris (FR)**

(54)  **QUANTUM SIMULATORS AND REMOTE COMPUTING SYSTEMS COMPRISING SUCH**

(57)      According to a first aspect, the present description relates to a quantum simulator (200) to simulate an evolution of a solution of a complex nonlinear equation. The quantum simulator comprises a first wavelength-tunable laser (201) configured to emit light with a tunable central wavelength; a vapor cell (205) comprising a gas of atoms or molecules at a given temperature; a beam shaper unit (203) arranged between said wavelength-tunable laser and said vapor cell and configured to modify the phase and/or the amplitude of the emitted light. The vapor cell is configured to receive light at the output of said beam shaper unit so that said light interacts with said gas to produce an output light; said interaction mapping the complex nonlinear equation with given initial conditions (21) and coefficient data (22) of said complex nonlinear equation. The quantum simulator further comprises a wavefront detector (207) configured to detect amplitude and/or phase of at least a portion of a wavefront of said output light and a processing unit (208) configured to calculate, from said phase and/or amplitude of the detected wavefront, output data (23) comprising a value of the solution of the complex nonlinear equation.

FIG.2

EP 4 167 148 A1

**Description**

TECHNICAL FIELD OF THE INVENTION

The present description relates to quantum simulators, and more precisely quantum simulators configured to simulate an evolution of a solution of a complex nonlinear equation. The present description further relates to methods for simulating an evolution of a solution of a complex nonlinear equation using such quantum simulators. The present description further relates to remote computing systems comprising such quantum simulators.

BACKGROUND OF THE INVENTION

Technological advancement and industrial development rely in particular on the solving of problems related to the behavior of real systems, *i.e.* systems that physically exist and on which measurements can be performed. Such problems are very diverse. They may comprise, for example, optimizing the shape of a wing to increase its lift, or predicting the weather in a predetermined region of the world at a future point in time knowing the weather at a previous time, i.e. the problem of weather forecast. Such problems may imply the solving of complex nonlinear equations. The example of weather forecast implies in particular the modelling of atmospheric dynamics and the solving of nonlinear equations that comprise Euler equations relating pressure field, density field and velocity vector field.

Generally, such problems are solved through the use of numerical simulations performed, for example, on a processing system such as a computer. In such systems, also referred to as numerical simulators in the present description, the equations of the physical model describing the problem are digitized and discretized in terms of bits. Such systems are configured to receive input data corresponding to a known initial state of the real system related to the problem, solve or find approximate solutions to the digitized equations of the physical model describing the problem, and generate output data forming a solution of the problem. In particular, said input data comprise coefficient data related to the equations of the physical model and initial or boundary conditions that are inferred from one or several known state(s) of the real system.

This process has proved an efficient scientific method over the years, however many problems still remain that cannot be easily simulated, for example problems in the field of high-energy, nuclear, atomic, and condensed matter physics, thermal rate constants and molecular energies.

As a matter of fact, for some of these problems, the simulation time (time required to provide the results of a simulation) increases too rapidly with the size and the number of variables of the system to simulate so that it becomes impractical to solve them using numerical simulations, even with the best available supercomputers. Further, numerical simulators generally use high energy consumption cooling systems which are barely compatible with environmental considerations that are becoming dominant nowadays.

Therefore, there has been interest in building quantum simulators that can provide both faster calculation time and lower power consumption than classical numerical simulators. Further, such quantum simulators can provide simulation of non-classical effects that are difficult or impossible to simulate with current numerical simulators.

As disclosed in [REF1], quantum simulators are controllable systems that are configured to mimic properties of a real system that is not as easily controllable. Such quantum simulators comprise, for example, systems based on superconducting circuits, systems based on atoms in Rydberg states, or systems based on trapped ions.

However, the current quantum simulators are generally difficult to operate and often require bulky equipment that renders their use impractical outside a laboratory environment. In particular, most of such quantum simulators require extremely cold temperature (below a few Kelvin) to be operational.

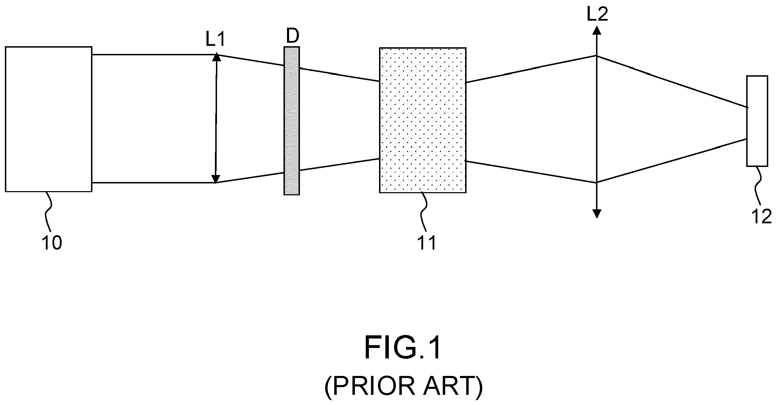

Interestingly, [REF2] discloses an experimental system suitable for studying a phenomenon of light waves condensation. Such experimental system relies on the propagation of light in a nonlinear medium consisting of a Rubidium (Rb) vapor cell, i.e. a cell comprising a gas of Rb atoms. As illustrated in FIG. 1, the experimental system comprises a laser source 10 emitting a light field that is sent to a diffuser D through a lens L1 to generate a speckle light field. Said speckle light field is sent to a Rb vapor cell 11 and, after propagation in the vapor cell 11, the amplitude of the speckle light field is sent through a lens L2 and measured using a CCD camera 12. In particular, [REF2] discloses that such experimental system can be used to observe phenomena described by the nonlinear Schrödinger equation and to explore different regimes of such equation without using extremely cold temperatures.

Inventors have shown for the first time how quantum simulators could benefit from the relative simplicity of operation of a quantum system comprising a vapor cell to provide quantum simulators that are more compact and easier to operate than quantum simulators of the prior art.

SUMMARY

In what follows, the term "comprise" is synonym of (means the same as) "include" and "contains", is inclusive and open, and does not exclude other non-recited elements. Moreover, in the present disclosure, when referring to a numerical value, the terms "about" and "substantially" are synonyms of (mean the same as) a range comprised between 80% and 120%, preferably between 90% and 110%, of the numerical value.

According to a first aspect, the present description relates to a quantum simulator to simulate an evolution of a solution of a complex nonlinear equation, the quantum simulator comprising:

- at least a first wavelength-tunable laser configured to emit light with a tunable central wavelength and a given power (total power expressed in Watts);
- a vapor cell comprising a gas of atoms or molecules at a given temperature;
- a beam shaper unit arranged between said at least first wavelength-tunable laser and said vapor cell and configured to modify the phase and/or the amplitude of the emitted light, wherein the vapor cell is configured to receive light at the output of said beam shaper unit so that said light interacts with said gas to produce an output light;
- a control unit configured to:
- receive input data comprising initial conditions and coefficient data of said of said complex nonlinear equation; and
- set the phase and/or the amplitude of the emitted light with the beam shaper unit, set the power and/or the central wavelength of the emitted light, and set the temperature of the gas so that the interaction between said light and said gas maps the complex nonlinear equation with said initial conditions and with said coefficient data.
- a wavefront detector configured to detect the phase and/or the amplitude of at least a portion of a wavefront of said output light;
- a processing unit configured to calculate, from said phase and/or amplitude of the detected wavefront, output data comprising a value of the solution of the complex nonlinear equation.

Such a quantum simulator can simulate an evolution, for example a time evolution or a spatial evolution, of a solution of a complex nonlinear equation, such solution being a mathematical function that is a solution of said complex nonlinear equation.

In particular, in the present description, a simulation of an evolution of a solution of a complex nonlinear equation is understood as a process by which one can obtain a value of said solution of the equation from initial conditions of said complex nonlinear equation. Said value of the solution of the complex nonlinear equation is derived from the output data calculated by the processing unit.

Advantageously, such initial conditions correspond to a known initial state of a real system, for example a 2D field of a physical parameter, for example a 2D pressure field in an atmospheric layer, and said value of a solution of a complex nonlinear equation corresponds to a state of said real system.

The values of the initial conditions and the values of the coefficient data of the equation are fed to the quantum simulator as input data.

Such evolution is an evolution with respect to at least one coordinate of the function that is solution to the complex nonlinear equation. For example, such evolution can be a time evolution or a spatial evolution.

In the present description, parameters of the quantum simulators can be defined, that are physical parameters of elements of the simulators, such elements being, for example, the vapor cell, the beam shaper unit and the laser. Such parameters comprise, for example, power of the emitted light, amplitude of the emitted light, phase of the emitted light, wavelength of the emitted light, frequency of the emitted light, temperature of the gas and composition of the vapor cell. At least some of such parameters can be modified.

The power of the emitted light is the total power of the emitted light expressed in Watts.

In a quantum simulator according to the present description, values of the initial conditions and values of the coefficient data of the complex nonlinear equation are used to set parameters of the quantum simulator.

In particular, the values of the initial conditions may be used to set the phase and/or the amplitude of the emitted light, said phase and/or amplitude being defined for example in a plane transverse to a direction of propagation of the emitted light.

Further, the values of the coefficient data may be used to set the power of the emitted light and/or the central wavelength (or frequency) of the emitted light, and the temperature of the gas.

Such an original quantum simulator uses a vapor cell that does not need ultra-cold temperatures, is easy to operate and compact. Therefore, such quantum simulator is easier to operate, less bulky and has a lower power consumption than quantum simulators of the prior art, for example quantum simulators based on superconducting circuits, trapped ions or Rydberg atoms.

According to one or further embodiments, said atoms or molecules are in a ground state.

According to one or further embodiments, the vapor cell comprises atoms among: Rubidium (Rb) atoms, Potassium (K) atoms, or Cesium (Cs) atoms.

According to one or further embodiments, the vapor cell comprises molecules among: Dinitrogen ($N_2$), Dioxygen ($O_2$), Sulfur Hexafluoride ($SF_6$).

According to one or further embodiments, said beam shaper unit comprises a spatial light modulator or a digital micromirror device.

According to one or further embodiments, said vapor cell further comprises a buffer gas, for example an inert gas comprising Helium (He) or Argon (Ar).

Such buffer gas provides a way to simulate evolution of a solution of a complex nonlinear equation comprising nonlinearities at lower laser powers and lower vapor cell temperatures, which reduces the energy consumption of the quantum simulator. In particular, it is possible to simulate evolution of a solution of a complex nonlinear equation comprising diffusion terms, in particular superdiffusion terms. Such superdiffusion terms can correspond, for example, to random walks comprising Levy flights.

According to one or further embodiments, said vapor cell further comprises a wall with an inner coating configured to prevent depolarization of atoms or molecules comprised in the vapor cell.

According to one or further embodiments, such inner coating comprises, for example, a paraffin coating.

According to a second aspect, the present description relates to a method to simulate an evolution of a solution of a complex nonlinear equation, such method comprising:

- emitting light with a tunable central wavelength and a given power;
- receiving input data comprising initial conditions and coefficient data of said complex nonlinear equation;
- setting the power and/or the central wavelength of the emitted light using said coefficient data;
- setting the phase and/or the amplitude of the emitted light using a beam shaper unit, using said initial conditions;
- making the light at the output of said beam shaper unit interact with a gas of atoms or molecules of given temperature in a vapor cell to produce an output light, wherein the central wavelength, power, phase and/or amplitude of the emitted light and the temperature of the gas are set such that said interaction maps the complex nonlinear equation with said initial conditions and said coefficient data;
- detecting the phase and/or the amplitude of at least a portion of a wavefront of said output light;
- calculating, from said phase and/or amplitude of the detected wavefront, output data comprising a value of the solution of the complex nonlinear equation.

According to one or further embodiments, said complex nonlinear equation is a nonlinear Schrödinger equation.

According to one or further embodiments, said complex nonlinear equation is a modified nonlinear Schrödinger equation further comprising terms that are proportional to the square of the power of the emitted light and/or terms that scale with the power of the emitted light to a power of four.

With such quantum simulators, it is possible to simulate phenomena corresponding to linear and/or quadratic interactions.

According to one or further embodiments, said complex nonlinear equation is a modified nonlinear Schrödinger equation comprising a nonlocal interaction term.

According to one or further embodiments, said complex nonlinear equation is a Euler 2D equation.

According to one or further embodiments, said input data comprise a two-dimensional field of a real system.

According to a third aspect, the present description relates to a remote computing system comprising:

- a quantum simulator according to the first aspect, configured to receive input data and to generate output data;
- a network communication unit;

wherein said network communication unit is configured to:

- receive user data from a distant user over a network and generate input data that are sent to said quantum simulator; and
- receive output data calculated by said quantum simulator and generate, from said output data, output user data, wherein said output user data are sent to the user over the network.

With such remote computing system, it is possible for a user to utilize the quantum simulator even though such user is not physically close to the quantum simulator. This is particularly advantageous if the user is distant from the quantum simulator but is connected to the quantum simulator via a network, for example an internet connection.

BRIEF DESCRIPTION OF DRAWINGS

Other advantages and features of the invention will become apparent on reading the description, illustrated by the following figures which represent:

- FIG. 1 (already described) is a schematic diagram illustrating a quantum system based on a Rb vapor cell, according to the prior art;
- FIG. 2 is a block diagram corresponding to the general configuration of a quantum simulator according to one or more embodiments; and
- FIGS. 3 is a block diagram corresponding to the general configuration of a remote computing system, according to one or more embodiments.

DETAILED DESCRIPTION

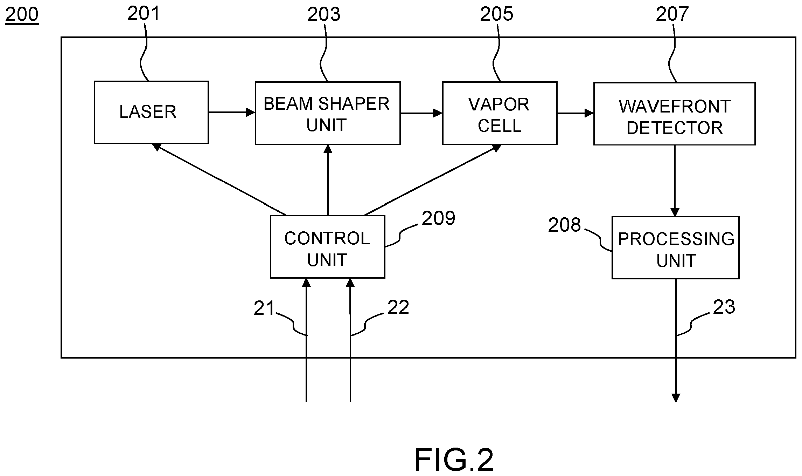

FIG. 2 is a block diagram corresponding to the general configuration of a quantum simulator according to one or more embodiments.

In the present description, the quantum simulator 200 is configured to simulate an evolution of a complex nonlinear equation. Such complex nonlinear equation describes a physical model related to a problem involving a real system, i.e., a system that physically exists and on which measurements can be performed.

As a non-limitative example, the problem can be weather forecast and the real system is the Earth's atmosphere. Such real system can therefore be modelled using atmospheric dynamics described by Euler equations.

The physical model has initial conditions 21 that are known, for example, by experimental measurements on the real system. In case where the real system is the Earth's atmosphere, such initial conditions 21 may comprise, for example, a matrix of values representing a two-dimensional velocity field of a slice of the atmosphere.

Further, the nonlinear equations describing the physical model have coefficient data 22.

The quantum simulator according to the present description receives, from a user, the initial conditions 21 and coefficient data 22, and generates output data 23 from which can be derived a state of the physical model obtained from a simulation of the evolution of a solution of said nonlinear equation from said initial conditions.

As shown in FIG. 2, the quantum simulator 200 is based on the propagation of light in a vapor cell 205, e.g. a vapor cell comprising Rb atoms, also referred to as Rb vapor cell.

The quantum simulator 200 comprises a laser 201 emitting light, such light being directed to a beam shaper unit 203 configured to modify the phase and/or amplitude of the emitted light. The emitted light is directed to the beam shaper unit 203 and passes through a vapor cell 205 in which it interacts with a gas comprising atoms or molecules.

Light at the output of the vapor cell 205, also referred to as output light, is detected by a wavefront detector 207. In particular, the phase and/or the amplitude of a wavefront of the output light is measured, for example in a plane transverse to a direction of propagation of said light.

The measured wavefront is sent to a processing unit 208 which generates, from such measured wavefront, the output data 23.

The laser 201 is a wavelength-tunable laser system configured to emit light with a central frequency or wavelength that can be tuned. For example, the laser 201 can be a semiconductor laser coupled into an optical fiber.

In embodiments, the quantum simulator 200 comprises more than one laser, for example two lasers emitting light at two different central wavelengths.

The choice of the central wavelength emitted by the laser depends on the atoms or molecules comprised in the vapor cell 205.

For example, in the case of Rubidium, the laser 201 can emit light at a central wavelength comprised between about 775 nm and about 795 nm, depending for example on the type of atomic transition of Rubidium that is used. In said case, the laser may be, for example, a Titanium Sapphire laser or a semiconductor laser emitting light at a wavelength comprised in said range. The laser may also be a telecom laser emitting light at a wavelength of about 1.55 microns whose frequency is doubled using, for example, a second harmonic generation unit.

The sign and value of the coefficients of the nonlinear equation can be changed by changing the wavelength of the emitted light, for example in order to introduce a defocusing or a focusing nonlinearity when interacting with Rubidium atoms.

The beam shaper unit 203 can comprise, for example, a spatial light modulator or a digital micromirror device configured to modify the amplitude and/or the phase of the emitted light.

The vapor cell 205 is a cell comprising a gas of atoms or molecules. As a non-limiting example, the vapor cell 205 may comprise a gas of Rubidium (Rb) atoms, for example a single isotope of Rubidium or a mixture of different isotopes of Rubidium such as a mixture of $^{85}$Rb and $^{87}$Rb.

The vapor cell 205 may comprise a cylindrical envelope, for example a substantially circular cylinder with a dimension along the cylinder axis comprised between about 1 mm and about 30 cm, for example about 10 cm.

The vapor cell 205 can be made of a material comprising, for example, Borosilicate glass or Quartz glass.

The cylindrical envelope of the vapor cell 205 can comprise at least a front facet and a rear facet, wherein light enters the vapor cell from the front facet and exits the vapor cell from the rear facet. The front facet and/or the rear facet can comprise a coating, in particular a coating configured to modify properties of light passing through the vapor cell 205.

EP 4 167 148 A1

Walls of the vapor cell, for example wall forming all or part of said cylindrical envelope, may comprise an inner coating configured to prevent depolarization of the atoms or molecules comprised in the vapor cell, in particular during collisions of the gas with the walls. Such inner coating can comprise, for example, a paraffin coating.

In some embodiments, the vapor cell 205 may comprise heating means configured to adjust the temperature of the gas. By adjusting the temperature of the gas, it is possible to adjust the atomic density $\rho$ of the atoms or molecules by several orders of magnitude.

As an example, the heating means may comprise resistive wires coiled around walls of the vapor cell 205. Such resistive wires can be heated up when connected to a voltage source. As a result, said walls of the vapor cell are also heated up to produce an increase in the temperature of the gas which, in turn, causes the density of the atoms or molecules of the gas to increase.

The wavefront detector 207 comprises, for example, a wavefront measurement device configured to measure the phase and/or the amplitude of a wavefront of the light impinging on a detection surface of the wavefront detector 207.

In particular, the wavefront detector 207 can be a Shack-Hartmann-based wavefront measurement device. The wavefront detector can also be a wavefront measurement device based on 4-wave lateral shearing interferometry configured to measure both the amplitude and the phase of the wavefront, such as devices of reference SID4® fabricated by Phasics®.

According to one or further embodiments, the wavefront detector 207 can be set to measure the entire wavefront of the light beam at the output of the vapor cell 205.

According to one or further embodiments, the wavefront detector 207 can be set to measure only a portion of the wavefront of the light beam at the output of the vapor cell 205.

Measuring only a portion of said wavefront increases measurement resolution on said portion of the wavefront without increasing simulation time. This is an advantage over numerical simulations wherein an increase in resolution drastically increases the simulation time.

The processing unit 208 may be a computing device comprising a memory for the storage of program instructions and a data processor, capable of executing program instructions stored in this memory, in particular to control the execution of at least one step of a method to simulate an evolution of a solution of a complex nonlinear equation according to the present description. The processing unit 208 can also be in the form of an integrated circuit, comprising electronic components suitable for implementing the function or functions described in this document for the processing unit. The processing unit can also be implemented by one or more physically distinct devices.

Interaction of light with the gas comprised in the vapor cell 205 can be described by a complex nonlinear equation verified by the 2D electromagnetic field representing said light.

The form of the nonlinear equation depends on values of parameters of the quantum simulator 200, such as, for example, the laser power, the laser central wavelength (or frequency) and the temperature of the gas. The parameters of the quantum simulator can also comprise the power and wavelength (or frequency) of other lasers in case the quantum simulator 200 comprises more than one laser.

As a result, specific combinations of parameters of the quantum simulator 200 can be used to select different regimes of nonlinearities in the interaction between the light and the gas and, therefore, to set specific forms of the nonlinear equation.

In particular, it is possible to choose a set of parameters so that such nonlinear equation is a nonlinear Schrödinger equation as follows:

$$i\frac{\partial \Psi}{\partial z} = -\frac{1}{2k_0}\nabla^2 \Psi + \gamma |\Psi|^2 \Psi$$

In this form, the nonlinear equation is verified by a function solution $\Psi(x, y, z)$ that is the 2D electromagnetic field in a plane (x,y) perpendicular to a direction (z) of propagation of light within the vapor cell 205. In particular, said nonlinear equation comprises two coefficients: a nonlinear coefficient, $\gamma$, and a wavenumber coefficient, $-1/(2 k_0)$, whose values are set via the parameters of the quantum simulator. The determination of the values of such specific parameters is for example disclosed in [REF2].

In embodiments, the quantum simulator simulates an evolution of the solution $\Psi(x, y, z)$ of this equation, from an initial state, the 2D electromagnetic field at the entrance of the vapor cell 205, to a final state; the 2D electromagnetic field at the output of the vapor cell.

The initial state is defined by the initial conditions 21 and the final state is measured with the wavefront detector 207 to generate output data 23.

The coefficients of the nonlinear equations are defined by the coefficient data 22. In particular, the parameters of the quantum simulator 200 are adjusted in order to set the values of the coefficients to adapt to the coefficient data 22. For example, the wavelength of the light emitted by the laser 201, the power of the light emitted by the laser 201

6

and the temperature of the gas comprised in the vapor cell 205 are adjusted.

The initial state is set with parameters of the quantum simulator 200 such as the amplitude and/or the phase of the 2D electric field at the entrance of the vapor cell 205 using the beam shaper unit 203. The setting can also comprise varying the power of the light emitted by the laser 201.

If a physical model with known initial conditions 21 and coefficient data 22 is described by said nonlinear Schrödinger equation, it is possible to set the parameters of the quantum simulator to match the physical model.

More generally, if a physical model with known initial conditions 21 and coefficient data 22 is described by a nonlinear equation that can be mimicked with the quantum simulator, it is possible to set the parameters of the quantum simulator to match the physical model.

In a quantum simulator according to the present description, based on the input data (i.e. the initial conditions 21 and the coefficient data 22), the control unit 209 may thus send instructions to the laser 201, the beam shaper unit 203 and the vapor cell 205 to modify the parameters of the simulator in order to adapt the initial state of the solution of the nonlinear equation and the coefficients of the nonlinear equation to the initial conditions 21 and coefficient data 22 sent by the user, respectively.

According to one or further embodiments, only few parameters of the quantum simulator 200 are modified, other parameters remaining constant.

According to one or further embodiments, the vapor cell can comprise a buffer gas so that the interaction time between light and the atoms or molecules of the gas is increased. Therefore, the nonlinear equation describing the interaction of light with gas in the vapor cell 205 may comprise a nonlocal interaction term and may be written as follows:

$$i\frac{\partial \Psi}{\partial z} = -\frac{1}{2k_0}\nabla^2 \Psi - i\frac{\eta}{2}\Psi + \gamma \Psi \int dr' \, U(r-r')\,|\Psi|^2(r',z)$$

wherein U(r) is a kernel of a nonlocal interaction function. U(r) can for example be of the form $U(r) = (2\pi\sigma^2)^{-1}\exp(-|r|/\sigma)$, with $\sigma$ as a nonlocal length scale.

According to embodiments, other types of nonlinear equations that can be solved using the quantum simulator 200 according to the present description comprise, for example, a modified nonlinear Schrödinger equation comprising a saturated nonlinearity, such as the equation hereafter.

$$i\frac{\partial \Psi}{\partial z} = -\frac{1}{2k_0}\nabla^2 \Psi - \exp(-\eta z)\,\Psi \int \frac{\gamma}{1+\beta|\Psi|^2}\,dr' \, U(|r-r'|)\,|\Psi|^2(r',z)$$

wherein $\beta$ is a nonlinearity saturation factor.

According to embodiments, other types of nonlinear equations that can be solved using the quantum simulator 200 according to the present description comprise coupled nonlinear equations.

Interestingly, 2D Euler equations can be put in the form of a nonlinear Schrödinger equation by a mapping using Madelung transformation. Therefore, according to embodiments, the control unit 209 may be configured to pre-process the input data corresponding to a 2D Euler equation in order to convert them into input data corresponding to a nonlinear Schrödinger equation. Therefore, the quantum simulator 200 according to the present description can be used to solve Euler 2D equations. This is particularly advantageous when simulating atmosphere dynamics, for example in order to determine weather forecast.

According to one or further embodiments, the quantum simulator 200 may be used remotely by a user, *i.e.* a user that cannot physically interact with the quantum simulator 200.

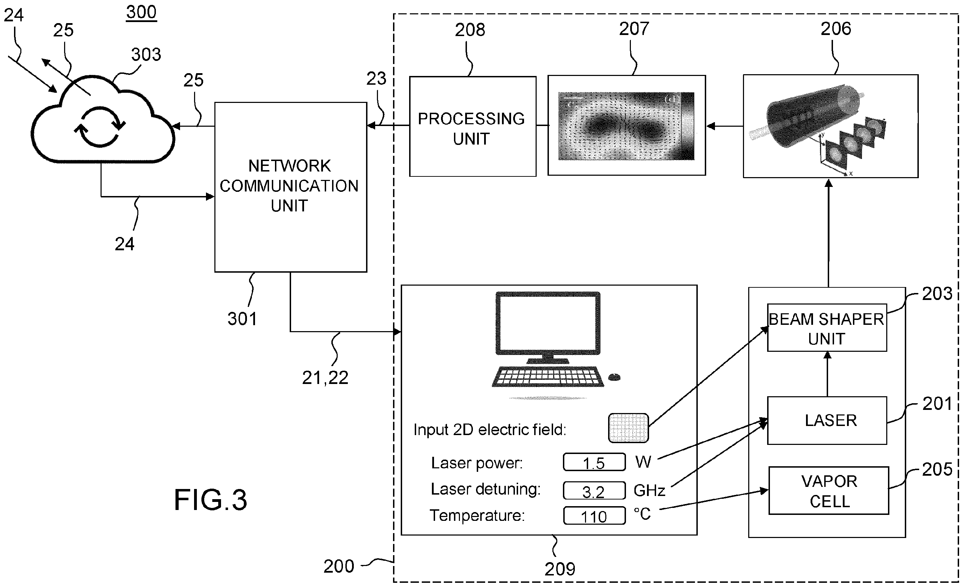

FIG. 3 is a block diagram corresponding to the general configuration of a remote computing system 300, according to one or more embodiments.

According to one or further embodiments, the remote computing system 300 comprises the quantum simulator 200 according to the present description, in communication with a network communication unit 301 connected to a network 303.

Generally, such remote computing system 300 can be used by a user that cannot physically interact with the quantum simulator 200, in order to simulate an evolution of a nonlinear equation.

The network communication unit 301 receives user data 24 from said user via a network 303, for example the internet network. Such network communication unit 301 generates, from the user data, initial conditions 21 and coefficient data 22 and send them to the control unit 209 of the quantum simulator 200.

As previously described, the control unit 209 calculates the values of the parameters of the quantum simulator 200 to adapt to the received initial conditions 21 and coefficient data 22, and send instructions to the laser 201, the vapor cell 205, and the beam shaper unit 203 to set the parameters of the quantum simulator 200 to said calculated values.

In the example of FIG.3, the parameters are the input 2D electric field, the laser power, the temperature of the gas comprised in the vapor cell 205, and the laser detuning (i.e. the frequency of the light emitted by the laser 201 with respect to a reference frequency, for example a resonance frequency of an atom or molecule of the gas).

Once the parameters are adjusted, the interaction of light with gas during propagation 206 of light throughout the vapor cell 205 results, at the output of the cell, in a wavefront that is detected by the wavefront detector 207 and sent to the processing unit 208. Such processing unit 208 generates output data 23 from said detected wavefront.

The output data 23 is received by the network communication unit 301 in order to generate output user data 25 that are sent to the user via the network 303.

While the invention has been described with respect to a limited number of embodiments, those skilled in the art, having benefit of this disclosure, will appreciate that other embodiments can be devised which do not depart from the spirit of the invention as disclosed herein. Accordingly, the scope of the invention should be limited only by the attached claims.

REFERENCES

[REF1] LAMATA, Lucas, PARRA-RODRIGUEZ, Adrian, SANZ, Mikel, et al. Digital-analog quantum simulations with superconducting circuits. Advances in Physics: X, 2018, vol. 3, no 1, p. 1457981.

[REF2] ŠANTIC, Neven, FUSARO, Adrien, SALEM, Sabeur, et al. Nonequilibrium precondensation of classical waves in two dimensions propagating through atomic vapors. Physical review letters, 2018, vol. 120, no 5, p. 055301.

**Claims**

1. A quantum simulator (200) to simulate an evolution of a solution of a complex nonlinear equation, the quantum simulator comprising:

   - at least a first wavelength-tunable laser (201) configured to emit light with a tunable central wavelength and a given power;
   - a vapor cell (205) comprising a gas of atoms or molecules at a given temperature;
   - a beam shaper unit (203) arranged between said at least first wavelength-tunable laser (201) and said vapor cell (205) and configured to modify the phase and/or the amplitude of the emitted light, wherein the vapor cell (205) is configured to receive light at the output of said beam shaper unit (203) so that said light interacts with said gas to produce an output light;
   - a control unit (209) configured to:

     - receive input data comprising initial conditions (21) and coefficient data (22) of said complex nonlinear equation; and
     - set the phase and/or the amplitude of the emitted light with the beam shaper unit (203), set the power and/or the central wavelength of the emitted light, and set the temperature of the gas so that the interaction between said light and said gas maps the complex nonlinear equation with said initial conditions (21) and with said coefficient data (22);

   - a wavefront detector (207) configured to detect the phase and/or the amplitude of at least a portion of a wavefront of said output light;
   - a processing unit (208) configured to calculate, from said phase and/or amplitude of the detected wavefront, output data (23) comprising a value of the solution of the complex nonlinear equation.

2. The quantum simulator according to claim 1, wherein said atoms or molecules are in a ground state.

3. The quantum simulator according to any of the preceding claims, wherein the vapor cell (205) comprises atoms among: Rubidium atoms, Potassium atoms, or Cesium atoms.

4. The quantum simulator according to any of claims 1 to 2, wherein the vapor cell (205) comprises molecules among: $N_2$, $O_2$, $SF_6$.

5. The quantum simulator according to any of the preceding claims, wherein said beam shaper unit (203) comprises a spatial light modulator or a digital micromirror device.

6. The quantum simulator according to any of the preceding claims, wherein said vapor cell (205) further comprises a buffer gas.

7. The quantum simulator according to any of the preceding claims, wherein said vapor cell (205) comprises a wall with an inner coating configured to prevent depolarization of atoms or molecules comprised in the vapor cell (205).

8. A method to simulate an evolution of a solution of a complex nonlinear equation, comprising:

   - emitting light with a tunable central wavelength and given power;
   - receiving input data comprising initial conditions (21) and coefficient data (22) of said complex nonlinear equation;
   - setting the power and/or the central wavelength of the emitted light using said coefficient data (22);
   - setting the phase and/or the amplitude of the emitted light using a beam shaper unit (203), using said initial conditions (21);
   - making the light at the output of said beam shaper unit interact with a gas of atoms or molecules of given temperature in a vapor cell (205) to produce an output light, wherein the central wavelength, power, phase and/or amplitude of the emitted light and the temperature of the gas are set such that said interaction maps the complex nonlinear equation with said initial conditions (21) and said coefficient data (22);
   - detecting the phase and/or the amplitude of at least a portion of a wavefront of said output light;
   - calculating, from said phase and/or amplitude of the detected wavefront, output data (23) comprising a value of the solution of the complex nonlinear equation.

9. The method according to claim 8, wherein said complex nonlinear equation is a nonlinear Schrödinger equation.

10. The method according to claim 8, wherein said complex nonlinear equation is a modified nonlinear Schrödinger equation comprising terms that are proportional to the square of the power of the emitted light and/or terms that scale with the power of the emitted light to a power of four.

11. The method according to claim 8, wherein said complex nonlinear equation is a modified nonlinear Schrödinger equation comprising a non-local interaction term.

12. The method according to claim 8, wherein said complex nonlinear equation is a Euler 2D equation.

13. The method according to claim 12, wherein said input data comprise a two-dimensional pressure field or a two-dimensional velocity field.

14. A remote computing system (300) comprising:

   - a quantum simulator (200) according to any of claims 1 to 7;
   - a network communication unit (301);

   wherein said network communication unit (301) is configured to:

   - receive user data (24) from a distant user over a network (303) and generate input data (21, 22) that are sent to said quantum simulator (200); and
   - receive output data (23) calculated by said quantum simulator (200) from said input data and generate, from said output data, output user data (25), wherein said output user data (25) are sent to the user over the network (303).

FIG.1
(PRIOR ART)

FIG.2

FIG.3

EP 4 167 148 A1

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CLARA PIEKARSKI ET AL: "Short Bragg pulse spectroscopy for a paraxial fluids of light", ARXIV.ORG, CORNELL UNIVERSITY LIBRARY, 201 OLIN LIBRARY CORNELL UNIVERSITY ITHACA, NY 14853, 25 November 2020 (2020-11-25), XP081822503, * the whole document * ----- | 1-14 | INV. G06N10/20 G06N10/40 |

TECHNICAL FIELDS
SEARCHED        (IPC)

G06N

The present search report has been drawn up for all claims

| Place of search | Date of completion of the search | Examiner |
|---|---|---|
| The Hague | 24 March 2022 | Papadakis, Georgios |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...................................................................

& : member of the same patent family, corresponding
    document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LAMATA, LUCAS ; PARRA-RODRIGUEZ, ADRIAN ; SANZ, MIKEL et al.** Digital-analog quantum simulations with superconducting circuits. *Advances in Physics: X,* 2018, vol. 3 (1), 1457981

- **ŠANTIĆ, NEVEN ; FUSARO, ADRIEN ; SALEM, SABEUR et al.** Nonequilibrium precondensation of classical waves in two dimensions propagating through atomic vapors. *Physical review letters,* 2018, vol. 120 (5), 055301